# EUROPÄISCHE PATENTANMELDUNG

(11) **EP 1 566 827 A1**
(43) Veröffentlichungstag der Anmeldung: **24.08.2005**
(21) Anmeldenummer: 04023122.7
(22) Anmeldetag: 29.09.2004
(51) Int. Cl.: H01J 37/34, C23C 14/35

(54) **Sputtervorrichtung mit einem Magnetron**

(30) Priorität: 18.02.2004 DE 102004007813
(71) Anmelder: Applied Films GmbH & Co. KG, 63755 Alzenau (DE)
(72) Erfinder: Lopp, Andreas, Dr., 63579 Freigericht-Somborn (DE); Jischke, Andreas, 63796 Kahl (DE); Geisler, Michael, Dr., 63607 Wächtersbach (DE); Pfeiffer, Herbert, 63477 Maintal (DE); Krempel-Hesse, Jörg, Dr., 63683 Eckartsborn (DE)
(74) Vertreter: Schickedanz, Willi

(57) **Zusammenfassung**

Die Erfindung betrifft eine Sputtervorrichtung mit einem Magnetron und einem Target, wobei Magnetron und Target relativ zueinander bewegbar sind. Das Magnetron weist hierbei ein Magnetsystem auf, das einen quasi-rechteckigen Plasmaschlauch bildet, dessen beiden Längsseiten einen Abstand C haben. Werden Target und Magnetsystem relativ zueinander um einen Weg bewegt, der etwa dem Abstand C entspricht, wird das Magnetsystem so ausgelegt, dass die Breite am Ende des Plasmaschlauchs (B) kleiner oder gleich dem Durchmesser des Plasmaschlauchs (d) ist. Ist der Weg der Relativbewegung (W) jedoch grosser als C, so wird das Magnetsystem so ausgelegt, dass die Breite (B) der Enden des Plasmaschlauchs kleiner oder gleich dem doppelten Durchmesser des Plasmaschlauchs (d) ist.

## Beschreibung

Die Erfindung betrifft eine Magnetanordnung nach dem Oberbegriff des Patentanspruchs 1.

Bei einer Sputteranlage wird im Vakuum ein Plasma in einer Sputterkammer erzeugt. Positive Ionen des Plasmas werden durch das negative Potential einer Kathode angezogen, die mit einem so genannten Target versehen ist. Auf diesem Target treffen die positiven Ionen auf und schlagen kleine Partikel heraus, die sich auf einem Substrat niederschlagen können. Das Herausschlagen dieser Partikel nennt man "Sputtern". Das Plasma besteht aus Gasen, die bei einem nicht-reaktiven Sputtern Edelgase, z. B. Argon, sein können. Bei reaktivem Sputtern wird z. B. Sauerstoff allein oder zusammen mit einem Edelgas verwendet.

Um den Sputtereffekt zu verbessern, werden in der Nähe des Targets Magnete eingesetzt, deren Magnetfeld das Plasma am Target hält. Hierbei werden die Elektronen im Plasma durch das Magnetfeld auf eine bestimmte Bahn gezwungen. Auf dieser Bahn ionisieren die Elektronen das Neutralgas, z. B. Argon, und erzeugen positive Ionen. Diese Ionen sind viel schwerer als die Elektronen und werden vom Magnetfeld so gut wie gar nicht beeinflusst. Sie fallen stattdessen auf das Target, das als negative Elektrode bzw. Kathode wirkt und zerstäuben dieses. Ionisierungen finden im Wesentlichen dort statt, wo der magnetische Feldvektor parallel zur Targetoberfläche verläuft. Das Plasma ist hier am dichtesten und daher wird das Target hier am stärksten erodiert. Die vom Magnetfeld bestimmte Plasmabahn wird im weiteren auch Plasmaschlauch genannt.

Werden planare Magnetsysteme verwendet, bei denen ein Stabmagnet einer ersten Polarität von einem Rechteckmagnet einer zweiten Polarität umgeben ist, so ergibt sich zwischen diesen Magneten eine rechteckige Erosionsspur, wobei die Ecken des Rechtecks abgerundet sind.

Es sind auch bereits rotierende zylindrische Targets bekannt, die um ein stationäres Magnetaggregat rotieren (DE 41 17 518 A1). Hierdurch gelangt die rechteckige Erosionsspur an alle Stellen des Umfangs des Targets. An den Schmalseiten des Erosionsrechtecks bildet sich eine Vertiefung im Target. Das Target wird gleichmäßig abgetragen, bis auf die Stellen, an denen die Schmalseiten des Plasmarechtecks eine unerwünschte Vertiefung erzeugen.

Weiterhin sind Magnetanordnungen bekannt, bei denen die Erosionsspur bei stehendem Target kein Rechteck mehr bildet, sondern ein Sechseck (WO 96/21750). Dieses Sechseck besteht aus zwei großen Seiten, an die sich rechts und links Dreiecke anschließen. Statt sich anschließenden Dreiecken können auch Parabeln oder Halbellipsen vorgesehen werden. Erreicht werden die veränderten Erosionskonturen durch eine entsprechende Anordnung der Magnete. Die Magnete können hierbei ortsfest angeordnet sein, während sich das Target um sie dreht; es kann aber auch das Target feststehen, während sich die Magnete drehen.

Es ist indessen auch eine Sputtervorrichtung bekannt, bei der eine Magnetanordnung mittels eines Antriebs parallel zur ebenen Oberfläche des Targets bewegt wird (US 5 873 989). Die Bewegung der Magnetanordnung geht hierbei hin und her, d. h. sie kehrt ihre Bewegungsrichtung an den Enden des Targets um. Das Plasma bildet eine Plasmaspur, welche die Form eines länglichen Ovals hat. Die Längsrichtung dieses Ovals erstreckt sich dabei senkrecht zur Bewegungsrichtung. Auch bei dieser Magnetanordnung entstehen dicht an den beiden Enden des Targets Vertiefungen, die größer sind als die Erosionen im übrigen Bereich des Targets. Um das Target besser auszunutzen, wird die Magnetanordnung nach einer gewissen Zeit um 90 Grad gedreht, sodass nun senkrecht zu den schon vorhandenen Vertiefungen zwei weitere Vertiefungen entstehen. Bei dieser Linear-Anordnung entstehen somit auf die gleiche Weise wie bei einer Rotations-Anordnung am Rand des Targets vertiefte Spuren.

Der Erfindung liegt die Aufgabe zugrunde, bei einer Linear-Sputteranlage, deren Magnete sich relativ zum Target bewegen, Erosions-Vertiefungen am Rand des Targets zu vermeiden.

Diese Aufgabe wird durch die Merkmale der Patentansprüche 1 oder 2 gelöst.

Die Erfindung betrifft somit eine Sputtervorrichtung mit einem Magnetron und einem Target, wobei Magnetron und Target relativ zueinander bewegbar sind. Das Magnetron weist hierbei ein Magnetsystem auf, das einen quasi-rechteckigen Plasmaschlauch bildet, dessen beiden Längsseiten einen Abstand C haben. Werden Target und Magnetsystem relativ zueinander um einen Weg bewegt, der etwa dem Abstand C entspricht, wird das Magnetsystem so ausgelegt, dass die Breite am Ende des Plasmaschlauchs kleiner oder gleich dem Durchmesser des Plasmaschlauchs ist. Ist der Weg der Relativbewegung jedoch kleiner als C, so wird das Magnetsystem so ausgelegt, dass die Breite d der Enden des Plasmaschlauchs kleiner oder gleich dem doppelten Durchmesser des Plasmaschlauchs ist.

Ausführungsbeispiele der Erfindung sind in den Zeichnungen dargestellt und werden im Folgenden näher beschrieben. Es zeigen:
Fig. 1 eine Prinzipdarstellung eines Magnetsystems, das sich über einem Target bewegt;
Fig. 2 einen Schnitt durch die Anordnung der Fig. 1;
Fig. 3 ein Magnetsystem, mit dem eine gleichmäßige Erosion eines Targets erreichbar ist;
Fig. 4 eine weitere Magnetanordnung, mit der eine gleichmäßige Erosion eines Targets erreichbar ist;
Fig. 5 einen Plasmaschlauch, der mit einer Magnetanordnung gemäß Fig. 3 oder Fig. 4 erzielt wird;
Fig. 6 ein weiteres Magnetsystem, das drei mittlere Magnete aufweist;
Fig. 7 Plasmaschläuche, die mit dem Magnetsystem gemäß Fig. 6 erzeugt werden.

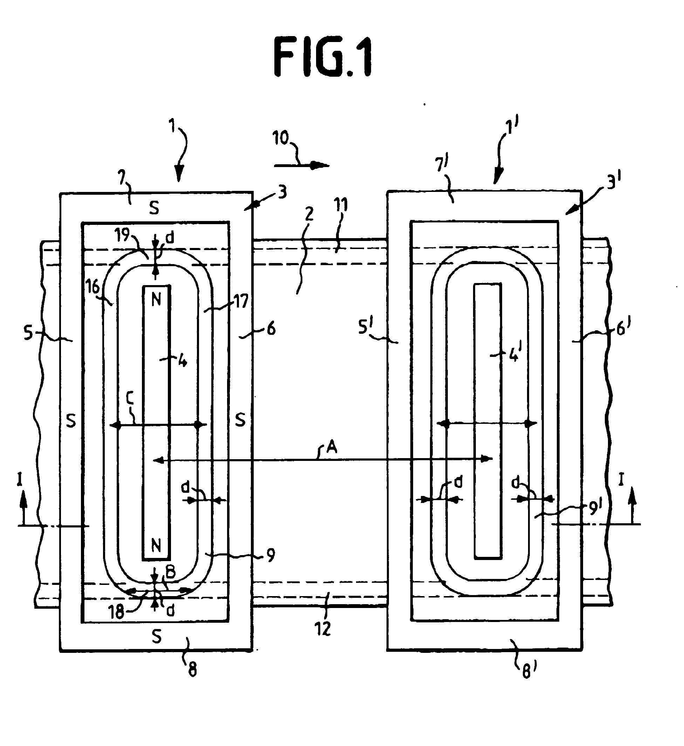

In der Fig. 1 ist ein Magnetsystem 1 dargestellt, das über einem Target 2 angeordnet ist. Das Target 2 besteht aus einem bestimmten Material, das zerstäubt und sich auf einem in Fig. 1 nicht dargestellten Substrat niederschlagen soll. Das Magnetsystem 1 weist einen äußeren Magneten 3 in Form eines Rahmens und einen inneren Magneten 4 in Form eines Stabs auf. Der Rahmen besteht aus zwei langen Stabmagneten 5, 6 und zwei kurzen Stabmagneten 7, 8, wobei die kurzen Stabmagneten 7, 8 senkrecht auf den langen Stabmagneten 5, 6 stehen. Diejenigen Seiten der langen und kurzen Stabmagneten 5, 6, 7, 8, auf die man sieht, sind beispielsweise Südpole, während diejenige Seite des inneren Magneten 4, auf die man sieht, ein Nordpol ist. Auf der nicht sichtbaren, dem Target 2 zugewandten Seite sind die Polverhältnisse umgekehrt. Die auf dieser nicht sichtbaren Seite verlaufenden Magnetfelder sind parabelförmig gekrümmt und verlaufen von dem äußeren Magneten 3 durch das Target 2 hindurch zum inneren Magneten 4. Durch diese Magnetfelder werden Elektronen so abgelenkt, dass ein Plasmaschlauch 9 gebildet wird, während positiv geladene Teilchen im Plasmaschlauch, z. B. Argon-Ionen, durch ein elektrisches Feld auf das Target beschleunigt werden. Dieser Plasmaschlauch 9 besteht aus den vertikalen Bereichen 16, 17 und den horizontalen Bereichen 18, 19. Entsprechend dem Plasmaschlauch 9 schlagen die Ionen auch aus der nicht sichtbaren Rückseite des Targets 2 Teilchen in Form des Plasmaschlauchs heraus, d. h. es bildet sich im Target eine Vertiefung in Form des Plasmaschlauchs 9. Wird das Magnetsystem 1 über das ortsfest verbleibende Target 2 in Richtung des Pfeils 10 bewegt, bis es die rechte Position einnimmt, so findet auf der Rückseite des Targets 2 eine im Wesentlichen gleiche Materialabtragung statt, mit Ausnahme der äußeren Randbereiche des Targets 2. In den Randbereichen bilden sich Vertiefungen oder Erosionskanäle 11, 12. Der Grund dafür, dass sich solche Vertiefungen 11, 12 bilden, ist folgender: Bei gleicher Breite bzw. Stärke d des vertikalen und horizontalen Bereichs des Plasmaschlauchs 9 treffen die Plasmateilchen im mittleren Bereich, der etwa durch die Länge des inneren Magneten 4 bzw. die Bereiche 18, 19 definiert wird, auf einen Streifen von 2 d des Targets 2, im Bereich der oberen und unteren Krümmung 18, 19 des Plasmaschlauchs 9 jedoch auf einen Streifen d x B, wobei B die Breite des Plasmaschlauchs im Krümmungsbereich und d der Durchmesser des Plasmaschlauchs ist. Da d x B > d x 2, werden die oberen und unteren Bereiche des Targets 2 stärker mit Ionen bombardiert als der mittlere Bereich. Es bilden sich somit die Vertiefungen 11, 12, die auch Erosionsgräben genannt werden.

Bei dem auf der rechten Seite dargestellten Magnetsystem 1' handelt es sich um das gleiche wie bei dem auf der linken Seite dargestellten Magnetsystem 1. Es nimmt lediglich eine andere Position ein, die mittels gestrichelten Bezugszahlen gekennzeichnet ist. Die Strecke A bezeichnet diejenige Strecke, um die das Magnetsystem 1 über dem Target 2 nach rechts verschoben wurde. In vielen Fällen wird die Strecke A so gewählt, dass sie der Strecke C, d. h. dem Abstand zwischen zwei langen Teilen 16, 17 des Plasmaschlauchs 9 entspricht.

Entspricht die Bewegung nach rechts der Strecke C, so wird das Magnetfeld so bewegt, dass im Verlauf der Bewegung jeder Teil der hinteren Targetoberfläche einmal von Plasma überdeckt ist. Bei einem großflächigen Target 2 kann dies mit mehreren nebeneinander angeordneten Magnetsystemen 1 realisiert werden. Die Bewegungsrichtung wird im Allgemeinen nach Durchfahren der Strecke C umgekehrt. Die Erosionstiefe auf dem Target 2 kann in diesem Fall durch die Integration der Erosionsrate entlang des Fahrwegs berechnet werden. Näherungsweise kann die Erosion auch durch die Breite d eines Arms 16, 17 des Plasmaschlauchs 9 abgeschätzt werden, der über einen Punkt auf der Targetoberfläche wandert.

An den oberen und unteren Enden des Plasmaschlauchs kommt es nur dann nicht zu den Vertiefungen oder Erosionskanälen 11, 12, wenn B ≤ d ist, konstante Plasmadichte vorausgesetzt.

Bei einer zweiten Ausführungsform 1 ist die Strecke A, um die das Magnetsystem 1 bewegt wird, größer als der Abstand C zwischen den Armen 16, 17. Das Magnetfeld des Magnetsystems 1 wird dabei so bewegt, dass im Laufe der Bewegung jeder Teil der Targetoberfläche einmal von den beiden senkrechten Armen des Plasmaschlauchs 9 überdeckt ist. Dies kann wieder mit mehreren Magnetsystemen 1 realisiert werden, die nebeneinander angeordnet sind. Die Bewegungsrichtung kehrt um, wenn der äußere Rand des Targets erreicht ist. Die Erosionstiefe kann auch in diesem Fall durch Integration der Erosionsrate entlang des Fahrwegs berechnet werden. Näherungsweise kann die Erosion durch die Summe aller Breiten d des Plasmaschlauchs abgeschätzt werden, die über einen Punkt an der Targetoberfläche wandern. Es kommt an den oberen und unteren Enden 18, 19 des Plasmaschlauchs 9 nur dann nicht zu Erosionsgräben 11, 12, wenn die Breite B des unteren bzw. oberen Arms 19, 18 des Plasmaschlauchs 9 maximal der doppelten Breite d des Plasmaschlauchs im vertikalen Arm entspricht, also B ≤ 2 d gilt, konstante Plasmadichte vorausgesetzt.

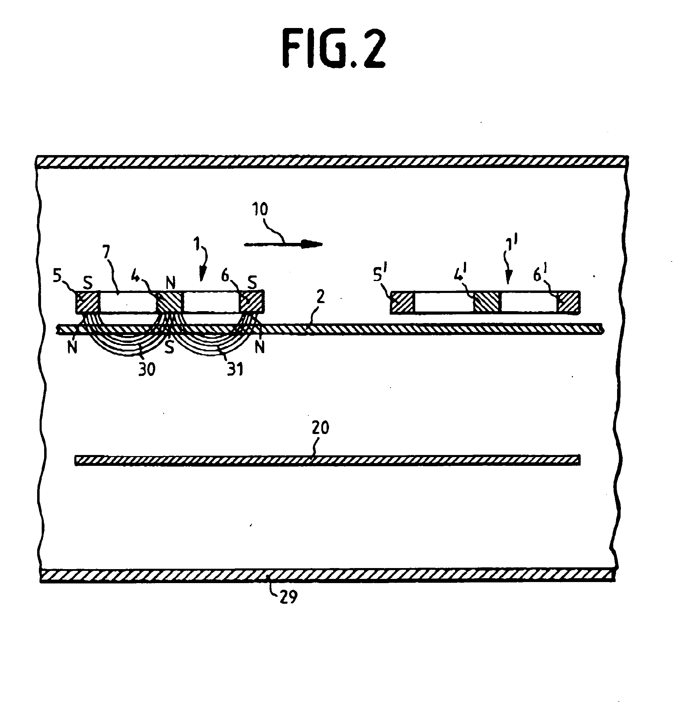

In der Fig. 2 ist ein Schnitt I-I durch die Anordnung gemäß Fig. 1 dargestellt. Man erkennt hierbei Magnetfelder 30, 31, die parabelförmig das Target 2 durchdringen. Unterhalb des Targets 2 befindet sich ein Substrat 20, das mit Partikeln, die aus dem Target 2 herausgeschlagen werden, beschichtet wird. In dem Raum zwischen Target 2 und Substrat 20 befindet sich Plasma, dessen positive Ionen auf eine nicht dargestellte negative Elektrode, die in der Regel mit dem Target 2 eine Einheit bildet, im Bereich des Magnetsystems beschleunigt werden und auf diese Weise Partikel aus dem Target 2 schlagen.

Die ganze in der Fig. 2 gezeigte Vorrichtung befindet sich in einer Vakuum-Beschichtungskammer 29.

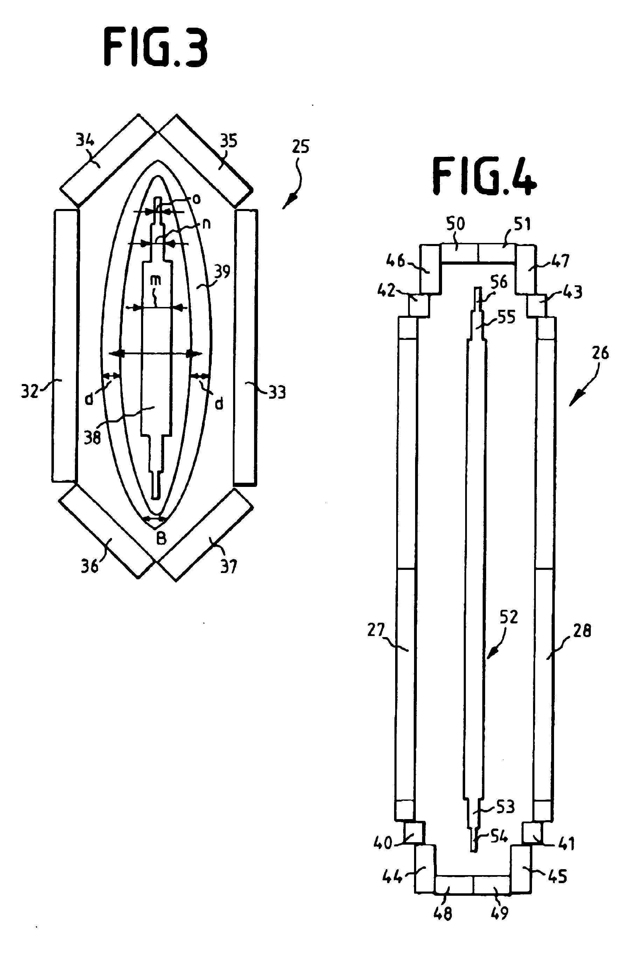

Die Fig. 3 zeigt ein besonderes Magnetsystem 25, das zwei vertikale lange Stabmagnete 32, 33 und vier kleinere Stabmagnete 34, 35, 36, 37 aufweist, von denen jeweils zwei 34, 35 bzw. 36, 37 eine Art Dach bilden, das die Enden der langen Stabmagnete 32, 33 abschließt.

Der innere Magnet 38 weist in Längsrichtung verschiedene Durchmesser auf, wobei der mittlere Teil den größeren Durchmesser m hat und die äußeren Teile kleinere Durchmesser n, o besitzen.

Fig. 4 zeigt ein weiteres Magnetsystem 26, das einen äußeren Magneten aufweist, der aus zwei langen Stabmagneten 27, 28, zwei versetzt hierzu angeordneten quadratischen Magneten 40, 41 bzw. 42, 43, zwei versetzt hierzu angeordneten kleinen Stabmagneten 44, 45 bzw. 46, 47 und zwei senkrecht hierzu verlaufenden kleinen Stabmagneten 48, 49 bzw. 50, 51 besteht.

Der innere Magnet wird durch einen Stabmagneten 52 gebildet, der an seinen Enden jeweils zwei Abstufungen 53, 54 bzw. 55, 56 mit kleinen Durchmessern aufweist.

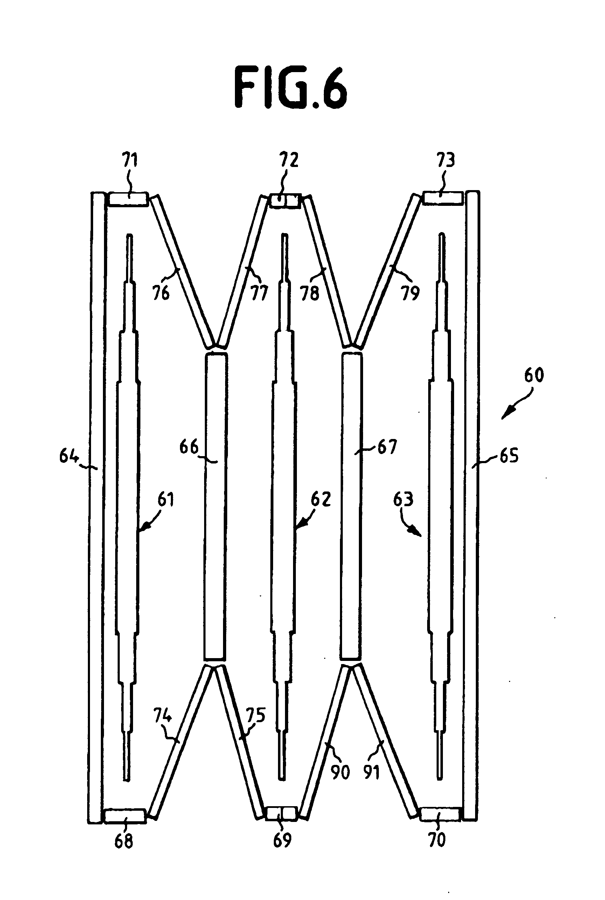

Die Fig. 5 zeigt einen Plasmaschlauch 57, der mittels des Magnetsystems gemäß Fig. 4 erzielt wird.

In der Fig. 6 ist eine weitere Magnetanordnung 60 dargestellt, die drei innere Magnete 61, 62, 63 aufweist, die von äußeren Magneten umgeben sind. Diese äußeren Magnete bestehen aus zwei äußeren langen Stabmagneten 64, 65, zwei zwischen diesen liegenden kurzen Stabmagneten 66, 67, jeweils drei senkrecht zu den Stabmagneten 64, 65 verlaufenden Endmagneten 68, 69, 70, 71, 72, 73, zwei schräg verlaufenden, das untere Ende des Stabmagneten 66 mit den Endmagneten 68 bzw. 69 verbindenden dünnen Stabmagneten 74, 75 sowie zwei schräg verlaufenden und das obere Ende des Stabmagneten mit den Endmagneten 71, 72 verbindenden dünnen Stabmagneten 76, 77. Außerdem sind die Endmagnete 69, 70 bzw. 72, 73 noch über dünne Stabmagnete 78, 79 mit den Enden des Stabmagneten 67 verbunden.

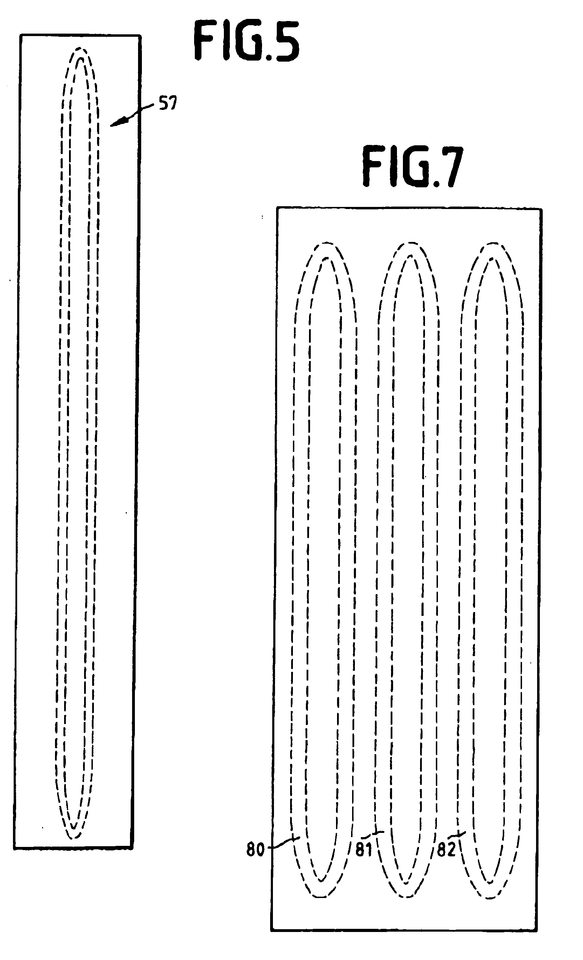

In der Fig. 7 sind drei Plasmaschläuche 80, 81, 82 dargestellt, die sich bei Verwendung des Magnetsystems 60 gemäß Fig. 6 ergeben.

Was die Bestimmung der Strecken B, d und C betrifft, so ist die Plasmabreite B nicht direkt zu bestimmen. B und d können deshalb nur über das Magnetfeld festgelegt werden, da dieses den Plasmaeinschluss bestimmt. Das Plasma brennt im Wesentlichen an den Stellen, an denen die Feldlinien und damit der magnetische Feldvektor parallel zur Targetoberfläche verlaufen. An diesen Stellen ist die in Bezug auf die Targetoberfläche senkrechte Komponente des magnetischen Feldvektors Null. Diese Stellen lassen sich experimentell durch Messen der Feldstärke an der Targetoberfläche bestimmen. Der Abstand C zweier Bereiche 16, 17 eines Plasmaschlauchs ist daher definiert durch den Abstand der Positionen an der Targetoberfläche in Richtung der Relativbewegung, an denen die senkrechte Komponente des Feldvektors Null wird. Entsprechend wird der Durchmesser d des Plasmaschlauchs 9 definiert als der Abstand der Positionen an der Targetoberfläche in Richtung der Relativbewegung, an denen der magnetische Feldvektor zur Targetoberfläche einen Winkel von 20° hat. Das entspricht den Stellen, an denen die Feldlinien die Targetoberfläche unter 20° schneiden. Die Positionen befinden sich dabei in der Mitte der Längsrichtung des Targets 2, also etwa dort, wo sich in Fig. 1 das Abstandssymbol für C befindet. Die Breite B des Plasmaschlauchs an den Schmalseiten wird als der maximale Abstand der Positionen an der Targetoberfläche in Richtung der Relativbewegung definiert, an denen der magnetische Feldvektor zur Targetoberfläche einen Winkel von 20° hat. Maximaler Abstand bedeutet in diesem Zusammenhang etwa den in der Mitte der Fig. 3 eingezeichneten Doppelpfeil. Wird er nach oben oder unten verschoben, wird der Abstand kleiner.

Die Größen B, d und C lassen sich somit über Messungen und/oder Rechnungen genau bestimmen.

## Patentansprüche

1. Sputtervorrichtung mit einem Magnetron und einem Target, wobei Magnetron und Target relativ zueinander bewegbar sind und das Magnetron ein Magnetsystem mit mindestens einem inneren Magneten und mindestens einem diesen umgebenden äußeren Magneten aufweist und wobei das Magnetsystem wenigstens einen geschlossenen Plasmaschlauch zwischen einem inneren und einem äußeren Magneten bildet, der zwei Bereiche mit einem Abstand C voneinander aufweist, die im Wesentlichen senkrecht zur Bewegungsrichtung des Magnetrons relativ zu einem Substrat verlaufen und die einen Durchmesser d aufweisen, **dadurch gekennzeichnet, dass** bei einer Relativbewegung zwischen Target (2) und Magnetsystem (1) um einen Weg W ≈ C das Magnetsystem (1) so ausgelegt ist, dass die Breiten B der Enden des Plasmaschlauchs (9) die Bedingung B ≤ d erfüllen.

2. Sputtervorrichtung mit einem Magnetron und einem Target, wobei Magnetron und Target relativ zueinander bewegbar sind und das Magnetron ein Magnetsystem mit mindestens einem inneren Magneten und mindestens einem diesen umgebenden äußeren Magneten aufweist und wobei das Magnetsystem wenigstens einen geschlossenen Plasmaschlauch zwischen einem inneren und einem äußeren Magneten bildet, der zwei Bereiche mit einem Abstand C voneinander aufweist, die im Wesentlichen senkrecht zur Bewegungsrichtung des Magnetrons relativ zu einem Substrat verlaufen und die einen Durchmesser d aufweisen, **dadurch gekennzeichnet, dass** bei einer Relativbewegung zwischen Target (2) und Magnetsystem (1) um einen Weg W > C das Magnetsystem (1) so ausgelegt ist, dass die Breiten B der Enden des Plasmaschlauchs (9) die Bedingung B ≤ 2 d erfüllen.

3. Sputtervorrichtung nach den Ansprüchen 1 oder 2, **dadurch gekennzeichnet, dass** der Abstand C zwischen den zwei Bereichen (16, 17) des Plasmaschlauchs (9) durch den Abstand zweier Positionen an der Oberfläche des Targets (2) in Richtung der Relativbewegung definiert ist, an denen die zur Oberfläche des Targets (2) senkrechte Komponente des magnetischen Feldvektors Null ist.

4. Sputtervorrichtung nach den Ansprüchen 1 oder 2, **dadurch gekennzeichnet, dass** der Durchmesser d des Plasmaschlauchs (9) durch den Abstand zweier Positionen an der Oberfläche und in der Mitte der Längsrichtung des Targets (2) in Richtung der Relativbewegung definiert ist, an denen der Feldvektor zur Oberfläche des Targets (2) einen Winkel von ca. 20° hat.

5. Sputtervorrichtung nach den Ansprüchen 1 oder 2, **dadurch gekennzeichnet, dass** die Breite B der Enden des Plasmaschlauchs (9) dem maximalen Abstand der Positionen an der Oberfläche des Targets (2) in Richtung der Relativbewegung entspricht, an denen der magnetische Feldvektor zur Oberfläche des Targets (2) einen Winkel von ca. 20° hat.

6. Sputtervorrichtung nach den Ansprüchen 1 oder 2, **dadurch gekennzeichnet, dass** es sich bei der Relativbewegung um eine hin- und hergehende Bewegung handelt.

7. Sputtervorrichtung nach den Ansprüchen 1 oder 2, **dadurch gekennzeichnet, dass** der äußere Magnet (25) zwei lange parallele Stabmagnete (32, 33) aufweist, deren Enden durch zwei ein Dach bildende kleine Stabmagnete (34, 35; 36, 37) abgeschlossen sind.

8. Sputtervorrichtung nach Anspruch 7, **dadurch gekennzeichnet, dass** der innere Stabmagnet an seinen Enden einen geringeren Durchmesser (n, o) aufweist als in seiner Mitte (m).

9. Sputtervorrichtung nach den Ansprüchen 1 oder 2, **dadurch gekennzeichnet, dass** drei innere (61 bis 63) und mehrere äußere Magnete (64 bis 75) vorgesehen sind, wobei ein Bereich (67) eines ersten äußeren Magneten gleichzeitig einen Bereich eines zweiten äußeren Magneten und ein Bereich des zweiten äußeren Magnets (66) gleichzeitig einen Bereich eines dritten äußeren Magneten bildet.

10. Sputtervorrichtung nach Anspruch 9, **dadurch gekennzeichnet, dass** der erste und der dritte äußere Magnet jeweils zwei parallel zueinander angeordnete Stabmagnete (64, 66; 65, 67) aufweisen, von denen der eine Stabmagnet (66, 67) kürzer als der andere (64, 65) ist, und dass die Enden der beiden Stabmagnete durch jeweils eine L-förmige Magnetanordnung (70, 91; 73, 79 bzw. 68, 74; 71 76) miteinander verbunden sind.
